# EUROPÄISCHE PATENTSCHRIFT

(11) **EP 0 855 455 B1**
(45) Veröffentlichungstag und Bekanntmachung des Hinweises auf die Patenterteilung: **28.02.2001**
(21) Anmeldenummer: 97122600.6
(22) Anmeldetag: 20.12.1997
(51) Int. Cl.: C30B 15/10, C30B 11/00, C30B 35/00

(54) **Tiegel zur Einkristall-Züchtung, Verfahren zu seiner Herstellung und seine Verwendung**
Crucible for single crystal growth, method for its manufacture and its application
Creuset pour la croissance de monocristaux, méthode de sa fabrication et sa mise en oeuvre

(30) Priorität: 24.01.1997 DE 19702465
(43) Veröffentlichungstag der Anmeldung: 29.07.1998
(73) Patentinhaber: W.C. Heraeus GmbH & Co. KG, 63450 Hanau (DE)
(72) Erfinder: Lupton, David Francis, Dr., 63571 Gelnhausen (DE); Schielke, Jörg, 63786 Bruchköbel (DE); Weigelt, Manfred, 63589 Linsengericht (DE); Petermann, Klaus, Dr., 22880 Wedel (DE); Mix, Eric, 20259 Hamburg (DE); Fornasiero, Livio, 22848 Norderstedt (DE)
(74) Vertreter: Kühn, Hans-Christian

(56) Entgegenhaltungen:
- DE-A- 3 230 389
- GB-A- 2 115 310
- US-A- 4 186 046
- PATENT ABSTRACTS OF JAPAN vol. 17, no. 577 (C-1122), 20.Oktober 1993 & JP 05 170588 A (SHIN ETSU CHEM CO LTD), 9.Juli 1993,
- PATENT ABSTRACTS OF JAPAN vol. 14, no. 211 (C-0715), 2.Mai 1990 & JP 02 047258 A (HITACHI LTD), 16.Februar 1990,

## Beschreibung

Die Erfindung betrifft einen Tiegel zum Züchten von Einkristallen aus der Schmelze in im wesentlichen inerter Atmosphäre, ein Verfahren zu seiner Herstellung und seine Verwendung.

Die Erfindung betrifft besonders einen Tiegel zum Züchten von hochschmelzenden Einkristallen, ganz besonders von Einkristallen aus hochschmelzenden Metalloxiden, vorzugsweise aus Erdalkalimetall- und Seltenerdmetalloxiden und -mischoxiden, in im wesentlichen inerter Atmosphäre.

Einkristalle - sie können reinst oder dotiert sein - werden vielseitig verwendet, z.B. als Hartmaterialien, Ziehsteine, Lagersteine, Schmucksteine, optische Elemente, Materialien für die Polarisationsoptik, Laser-Kristalle, elektrooptische Bauelemente, Halbleiter und Speicher-Kristalle in der Datenverarbeitung.

Die Herstellung der Einkristalle erfolgt meist durch Züchtung aus der Schmelze. Dabei wird zwischen Zieh- und Senkverfahren und Verfahren mit und ohne Tiegel unterschieden. Als Materialien für die Tiegel eignen sich besonders Graphit, Edelmetalle (Platin, Iridium, Rhodium, Gold) und Edelmetall-Legierungen. Die hauptsächlichsten Tiegel-Verfahren sind das Bridgman-Stockbarger-Verfahren, das Nacken-Kyropoulos-Verfahren und das Czochralski-Verfahren.

Beim Bridgman-Stockbarger-Verfahren entsteht der Einkristall durch Auskristallisieren, wenn der die Schmelze enthaltende Tiegel aus einem Ofenbereich hoher Temperatur in einen Ofenbereich niedrigerer Temperatur gebracht wird. Für dieses Verfahren geeignete Tiegel besitzen im allgemeinen eine zylindrische Form und einen sich konisch verengenden Boden, der in eine Kapillare ausläuft. Zur Züchtung von Einkristallen aus sauerstoff- und feuchtigkeitsempfindlichen Substanzen unter Schutzgas oder Vakuum können Graphit-Tiegel benutzt und damit Temperaturen bis über 2000 °C erzielt werden (Ullmanns Encyklopädie der technischen Chemie, 4. Auflage, Band 15 (1978), 138 - 140).

Beim Nacken-Kyropoulos-Verfahren befindet sich der Tiegel in einem Rohrofen und wird die in dem Tiegel vorhandene Schmelze durch einen gekühlten Impfkristall zur Kristallisation gebracht. Charakteristisch für dieses Verfahren ist eine lange Ofenzone mit homogener Temperatur und eine überhitzte Schmelze, in die der wachsende Kristall infolge der Kühlung tief eintaucht (Ullmanns Encyklopädie der technischen Chemie, 4. Auflage, Band 15 (1978), 139 - 140).

Das Czochralski-Verfahren ist eines der wichtigsten Verfahren zum Züchten von Einkristallen. Bei diesem Verfahren werden die zur Bildung des Einkristalls vorgesehenen Substanzen in einem beheizten Tiegel geschmolzen und dann die erhaltenen Schmelzen mit einem an einem Halter (Impfkristallhalter) befestigten Impfkristall in Berührung gebracht. Die an dem Impfkristall wachsenden Einkristalle werden zusammen mit dem Impfkristall mit konstanter Geschwindigkeit aus der Schmelze gezogen (Ziehrichtung senkrecht zur Oberfläche der Schmelze) und, wenn ihr Wachstum beendet ist, von Schmelze und Impfkristall getrennt.

Die Tiegel bestehen üblicherweise aus Edelmetallen. So werden zum Beispiel zur Züchtung von Rubinen nach dem Czochralski-Verfahren Tiegel aus Iridium eingesetzt, wobei zum Schutz des Iridiums in einer Argon-Atmosphäre mit 1 - 3 % Sauerstoff gearbeitet wird. Zur Züchtung niedriger schmelzender Oxide eignen sich Tiegel aus Platin, Rhodium oder Edelmetall-Legierungen (Ullmanns Encyklopädie der technischen Chemie, 4. Auflage, Band 15 (1978), 140 bis 142; US 4 483 734 A). Während der Züchtung befinden sich die Tiegel in einer Einkristall-Zuchtapparatur, die mit einer Tiegel-Heizung und einer Wärmeisolation versehen ist.

US 4 186 046 A betrifft das Züchten von Einkristallen aus keramischen Oxiden nach einem eine Modifikation der Gradientofen-Technik darstellenden Verfahren. Dabei werden die keramischen Oxide in einem aus hochschmelzendem Material bestehenden Tiegel geschmolzen. Das hochschmelzende Material kann Molybdän, Wolfram, Iridium, Rhenium oder ein damit überzogenes Material sein. Als keramische Oxide werden Y₃Al₅O₁₂, Al₂O₃, MgAl₂O₄, Al₂O₃/ZrO₂ und Al₂O₃/Y₃Al₅O₁₂ genannt.

Aus DE 33 01 831 A1 ( US 4 444 728 A) ist ein aus einer Iridium-Rhenium-Legierung mit etwa 1 - 20, besonders etwa 1 - 15 Gewichts-Teilen Rhenium bestehender Tiegel zum Züchten von Einkristallen bekannt. Der Tiegel weist einen Schmelzpunkt von etwa 2450 - 2540 °C auf und wird durch Warmverformung und anschließende Verarbeitung von Iridium/Rhenium, das durch Sintern oder Gießen von Mischungen aus Iridium- und Rhenium-Pulver erhalten wurde, hergestellt. Er wird bevorzugt eingesetzt, um nach dem Czochralski-Verfahren unter Anwendung einer im wesentlichen inerten Atmosphäre Einkristalle aus Gadolinium-gallium-granat zu züchten. Dabei besteht die im wesentlichen inerte Atmosphäre aus einer inerten oder leicht oxidierenden Atmosphäre, wie Stickstoff, Argon, Helium, CO/CO₂- oder N₂/O₂-Gemischen; bevorzugt wird eine Atmosphäre aus 98 Volumen-% Stickstoff und 2 Volumen-% Sauerstoff. In DE 33 01 831 A1 wird darauf hingewiesen, daß - wie bekannt - die Oxidationsbeständigkeit des Rheniums geringer ist als die des Iridiums und daß sich Rhenium durch intensive Oxidation bei hohen Temperaturen rasch zersetzt.

Tiegel aus Iridium und aus Werkstoffen auf Iridium-Basis können zum Züchten von Einkristallen aus Schmelzen mit Temperaturen bis etwa 2200 °C eingesetzt werden. Bei der Züchtung hochschmelzender Kristalle fehlt es jedoch meist an chemisch und thermisch ausreichend resistenten Tiegelmaterialien, so daß diese Kristallarten häufig nur durch tiegelfreie Verfahren oder durch Kalttiegel-Verfahren hergestellt werden können.

Der Erfindung liegt daher die Aufgabe zugrunde, einen Tiegel zum Züchten von hochschmelzenden Einkristallen aus der Schmelze in im wesentlichen inerter Atmosphäre und ein Verfahren zu seiner Herstellung zu finden. Der Tiegel soll besonders für die Einkristall-Züchtung von hochschmelzenden Metalloxiden geeignet sein und beim Bridgman-Stockbarger-, Nacken-Kyropoulos- und Czochralski-Verfahren eingesetzt werden können.

Der die Lösung der Aufgabe darstellende Tiegel ist erfindungsgemäß dadurch gekennzeichnet, daß er aus gesintertem Rhenium besteht.

Bevorzugt wird ein Tiegel aus gesintertem Rhenium mit einer Dichte von etwa 88 - 95 % der theoretischen Dichte.

In einer besonderen Ausführungsform kann der Tiegel mit einer angeschweißten Halterung aus Rhenium, vorzugsweise aus Rhenium-Draht, versehen sein. Diese Form des Tiegels wird bevorzugt, wenn - bei hohen Temperaturen - eine direkte Berührung von Tiegel und Wärmeisolation und damit ihre Reaktion miteinander vermieden werden muß. In diesem Fall kann der mit der Halterung versehene Tiegel so an einer Aufhängevorrichtung befestigt werden, daß er die Wärmeisolation nicht berührt.

Im Sinne der Erfindung wird unter einer im wesentlichen inerten Atmosphäre eine inerte oder leicht reduzierende Atmosphäre, beispielsweise aus Helium, Argon, Stickstoff oder einem Argon-Wasserstoff-Gemisch mit 5 Volumen-% Wasserstoff, verstanden

Das die weitere Lösung der Aufgabe der Erfindung darstellende Verfahren zur Herstellung des Tiegels ist erfindungsgemäß dadurch gekennzeichnet, daß aus feinem Rhenium-Pulver durch isostatisches Kaltpressen mit einem Druck von 300 - 700 MPa ein Tiegel-Preßling erzeugt und dieser bei 500 - 2800 °C im Vakuum gesintert wird.

Unter feinem Rhenium-Pulver wird im Sinne der Erfindung vorzugsweise ein Rhenium-Pulver mit einer mittleren Korngröße von 1 - 20 Mikrometer verstanden. Durch Reduktion von Ammoniumperrhenat mit Wasserstoff hergestelltes Rhenium-Pulver hat sich als sehr gut geeignet erwiesen (Ullmann's Encyclopedia of Industrial Chemistry, 5. Edition, Volume A 23, 1993, 202 - 203).

Das Verfahren hat sich besonders bewährt, wenn Rhenium-Pulver mit einer Reinheit von mindestens 99,8 % und einer mittleren Korngröße von 3 - 12 Mikrometer eingesetzt wird.

Eine bevorzugte Ausführungsform der Erfindung bezieht sich auf einen Tiegel aus gesintertem Rhenium mit einer Dichte von 90 % und das Verfahren zur Herstellung des Tiegels aus Rhenium-Pulver mit einer Reinheit von 99,99 % und einer mittleren Korngröße von 6,6 Mikrometer durch isostatisches Kaltpressen mit einem Druck von 700 MPa und anschließendes Sintern bei 500 - 2500 °C , wie in dem Beispiel 1 beschrieben. Die Bedingungen des Sinterns, die so zu wählen sind, daß ein Tiegel mit der geforderten Dichte entsteht, werden durch Vorversuche bestimmt.

Der erfindungsgemäße Tiegel hat sich besonders bewährt, wenn er zur Züchtung von Einkristallen aus Oxiden mit einem Schmelzpunkt von über 2000 °C, bevorzugt mit einem Schmelzpunkt im Bereich von 2400 - 2500 °C, benutzt wird; die in dem Rhenium-Tiegel befindlichen Schmelzen können Temperaturen bis etwa 2800 °C aufweisen.

Überraschenderweise ist trotz der bekannten Empfindlichkeit des Rheniums gegenüber Sauerstoff die Verträglichkeit des Rheniumtiegels mit den oxidischen Schmelzen sehr gut; eine Reduktion der oxidischen Schmelzen und eine Verunreinigung der Schmelzen und Einkristalle durch das Tiegelmaterial werden nicht beobachtet.

Ebenfalls überraschend ist die bessere Zeitstandfestigkeit der für den erfindungsgemäßen Tiegel eingesetzten Form des Rheniums - gesintertes Rhenium mit einer Dichte von etwa 88 bis 95 % der theoretischen Dichte - im Vergleich zu Rhenium in dichter, rekristallisierter Form und zu schmelzmetallurgisch gewonnenem Iridium, wie durch Zeitstandversuche bei Temperaturen bis zu 3000 °C festgestellt wurde (Beispiel 3). Bei einer Standzeit von 10 Stunden besitzt das gesinterte Rhenium mit einer Dichte von 90 % noch bei 2800 °C eine Festigkeit von etwa 5,0 MPa, das dichte, rekristallisierte Rhenium hingegen eine Festigkeit von nur 4,2 MPa. Zum Vergleich: Iridium hat bei 2200 °C eine Festigkeit von 5,0 MPa.

Der erfindungsgemäße Tiegel wird vorzugsweise zur Züchtung von Einkristallen aus Oxiden und Mischoxiden der Erdalkalimetalle (Beryllium bis Barium) und der Seltenerdmetalle (Scandium, Yttrium und Lanthan bis Lutetium) eingesetzt. Mit besonderem Erfolg lassen sich Einkristalle aus Scandiumoxid, Sc₂O₃, Yttriumoxid, Y₂O₃, Scandium-yttrium-oxid, ScYO₃, Holmiumoxid, Ho₂O₃, Lutetiumoxid, Lu₂O₃, und Lutetium-yttrium-oxid, LuYO₃, nach dem Bridgman-Stockbarger-, dem Nacken-Kyropoulus- und dem Czochralski-Verfahren züchten.

Die mit Hilfe des erfindungsgemäßen Tiegels gezüchteten Erdalkalimetall- und Seltenerdmetalloxid- und -mischoxid-Einkristalle sind fehler- und spannungsfrei und zeichnen sich durch ihre Größe, Reinheit und optische Qualität aus, so daß sie sehr gut für optische Bauelemente, als Substrate für Halbleiterschichten und - bei geeigneter Dotierung - als Laser-Kristalle verwendet werden können.

Zur näheren Erläuterung der Erfindung werden in den folgenden Beispielen ein Tiegel aus gesintertem Rhenium und seine Herstellung (Beispiele 1 und 2) und die Bestimmung der Zeitstandfestigkeit von Proben aus a) gesintertem Rhenium mit einer Dichte von 90 % der theoretischen Dichte, b) dichtem, rekristallisiertem Rhenium und c) schmelzmetallurgisch gewonnenem Iridium (Beispiel 3) beschrieben.

### Beispiel 1

### Tiegel-Herstellung

Durch Reduktion von Ammoniumperrhenat mit Wasserstoff gewonnenes Rhenium-Pulver mit einer Reinheit von 99,99 % und einer mittleren Korngröße von 6,6 Mikrometer wird in eine mit einem feingeschliffenen Stahl-Kern versehene Gummi-Form gefüllt. Die Größe und Gestalt der Gummi-Form und des den späteren Tiegel-Innenraum bildenden Stahl-Kerns werden der gewünschten Größe und zylindrischen Gestalt des Tiegels entsprechend gewählt. Die mit dem Stahl-Kern und dem Rhenium-Pulver gefüllte Gummi-Form wird mit einem Gummi-Stopfen dicht verschlossen und in ein Öl-Bad gelegt. Durch isostatisches Kaltpressen mit einem hydrostatischen Druck von 700 MPa wird das in der Gummi-Form enthaltene Rhenium-Pulver zu einem Tiegel-Preßling verdichtet. Nach Entfernen von Gummi-Stopfen und Stahl-Kern wird der Tiegel-Preßling der Gummi-Form entnommen und unter Vakuum (10⁻⁴ bis 10⁻⁵ mbar) gesintert, zunächst für jeweils 1 Stunde bei 500 °C, 750 °C, 1000 °C und 1200 °C, dann für 2 Stunden bei 1500 °C und zum Schluß für 3 Stunden bei 2500 °C. Aus dem so erhaltenen gesinterten Tiegel-Rohling wird durch Nachbearbeitung (Drahterodieren und Schleifen) der fertige Tiegel aus gesintertem Rhenium gewonnen. Der zylindrische Tiegel besteht aus gesintertem Rhenium mit einer Dichte von 90 % der theoretische Dichte und weist einen Innendurchmesser von 18 mm, eine Wanddicke von 2,5 mm und eine Innenraum-Höhe von 20,5 mm auf.

### Beispiel 2

### Tiegel-Herstellung

Durch Reduktion von Ammoniumperrhenat mit Wasserstoff gewonnenes Rhenium-Pulver mit einer Reinheit von 99,98 % und einer mittleren Korngröße von 10 Mikrometer wird in eine mit einem feingeschliffenen Stahl-Kern versehene Gummi-Form gefüllt. Die Größe und Gestalt der Gummi-Form und des den späteren Tiegel-Innenraum bildenden Stahl-Kerns werden der gewünschten Größe und zylindrischen Gestalt des Tiegels entsprechend gewählt. Die mit dem Stahl-Kern und dem Rhenium-Pulver gefüllte Gummi-Form wird mit einem Gummi-Stopfen dicht verschlossen und in ein Öl-Bad gelegt. Durch isostatisches Kaltpressen mit einem hydrostatischen Druck von 300 MPa wird das in der Gummi-Form enthaltene Rhenium-Pulver zu einem Tiegel-Preßling verdichtet. Nach Entfernen von Gummi-Stopfen und Stahl-Kern wird der Tiegel-Preßling der Gummi-Form entnommen und unter Vakuum (10⁻⁴ bis 10⁻⁵ mbar) gesintert, zunächst für jeweils 1 Stunde bei 500 °C, 750 °C, 1000 °C und 1200 °C, dann für 2 Stunden bei 1500 °C und zum Schluß für 3 Stunden bei 2500 °C. Aus dem so erhaltenen gesinterten Tiegel-Rohling wird durch Nachbearbeitung (Drahterodieren und Schleifen) der fertige Tiegel aus gesintertem Rhenium gewonnen. Der zylindrische Tiegel besteht aus gesintertem Rhenium mit einer Dichte von 90,3 % der theoretische Dichte und weist einen Innendurchmesser von 18 mm, eine Wanddicke von 2,5 mm und eine Innenraum-Höhe von 20,5 mm auf.

### Beispiel 3

### Bestimmung der Zeitstandfestigkeit

Die Zeitstandversuche zur Bestimmung der Zeitstandfestigkeit erfolgen in der in DD 245 576 A3 beschriebenen Anordnung. Mit Hilfe dieser Anordnung werden
a) aus gesintertem Rhenium mit einer Dichte von 90 % bestehende Proben mit einem Querschnitt von 1 x 1 mm² und einer Länge von 120 mm in einer Atmosphäre aus Argon und 5 Volumen-% Wasserstoff,
b) aus rekristallisiertem Rhenium mit einer Dichte von über 99 % der theoretischen Dichte bestehende Proben mit einem Durchmesser von 2 mm und einer Länge von 120 mm in einer Atmosphäre aus Argon und 5 Volumen-% Wasserstoff und
c) aus Iridium bestehende Proben mit einem Querschnitt von 1 x 1 mm² und einer Länge von 120 mm in einer Argon-Atmosphäre
auf definierte Temperaturen im Bereich von 2000 bis 3000 °C erwärmt und dann definierten Zugbelastungen bis zum Bruch der Proben ausgesetzt. Dann werden Zeitstand-Schaubilder, die die bis zum Bruch verstrichene Zeit in Abhängigkeit von der Zugbelastung zeigen, angefertigt. Die Zugbelastung, die den Bruch nach 10 Stunden bewirkt, wird durch Interpolation des jeweiligen Schaubildes ermittelt und als Zeitstandfestigkeit R_{m/10 h} [MPa] in der Tabelle angegeben.

| Temperatur [°C] | Zeitstandfestigkeit R_{m/10h} [MPa] | | |
|---|---|---|---|
| | a) Re, 90 % dicht | b) Re, >99 % dicht | c) Ir, schmelzmetallurg. |
| 2000 | - | - | 9,00 |
| 2100 | 12,50 | 24,00 | - |
| 2200 | - | - | 5,00 |
| 2300 | - | - | 2,30 |
| 2500 | 6,00 | 18,00 | nm |
| 2700 | - | 9,10 | nm |
| 2800 | 5,00 | 4,20 | nm |
| 3000 | 3,40 | nm | nm |
| nm: Messung nicht möglich wegen zu geringer Materialfestigkeit (bzw. Temperatur > Schmelzpunkt) -: Messung nicht durchgeführt | | | |

### Ausführungsbeispiel für die Kristallzucht

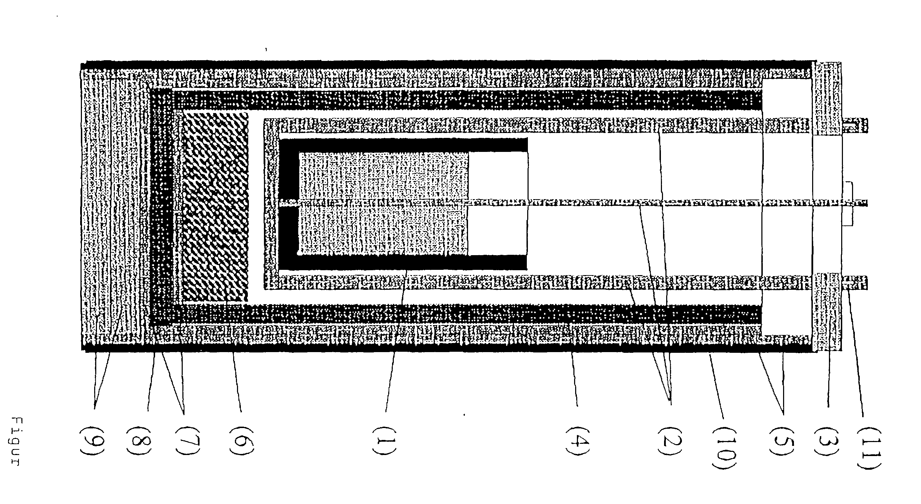

Das Ausführungsbeispiel in der Figur zeigt einen Isolationsaufbau, wie er für die Czochralski-Zucht hochschmelzender Oxide für Temperaturen bis maximal 2800°C verwendet wird.
Der mit dem pulverförmigen Oxid befüllte Tiegel (1) steht in einem Käfig aus Rhenium-Profilen (2) und ist von oben in ein mit Isolationsmaterialien ausgekleidetes Quarzglasrohr (10) gehängt. Der Käfig ist mit Rheniumsplinten (11) an einem Aluminiumoxidring (3) gesichert, der auf dem Quarzglasrohr aufliegt. Zur thermischen Isolation ist der Käfig mit Tiegel von einem Zirkonoxid-Rohr (4) umgeben, das von zwei Zirkonoxid-Matten (5) umschlossen wird. Die thermische Isolation unter dem Tiegel besteht aus Zirkonoxid-Granulat (6), einer Zirkonoxid-Matte (7), einer Zirkonoxidscheibe (8), einer weiteren Matte aus Zirkonoxid (7) und zwei Aluminiumoxid-Scheiben (9).
Der ganze Aufbau wird zentrisch in der Induktionsspule im Kessel der Zuchtanlage so eingebaut, daß die Induktionsspule den Tiegel optimal beheizt.
Zur Kristallzüchtung wird der Kessel zunächst evakuiert und anschließend mit einem inerten oder reduzierenden Zuchtgas (Stickstoff oder Edelgas bzw. Wasserstoff) durchströmt.
Nachdem das in den Tiegel eingefüllte Oxid aufgeschmolzen ist, wird von oben eine rotierende Ziehstange aus Rhenium oder ein Impflinghalter mit einem Impfkristall mit der Schmelze in Kontakt gebracht. Nach dem Animpfen wird die Ziehstange bzw. der Impflinghalter mit dem entstehenden Kristall mit Raten von typischerweise 0.5-3mm/h aus der Schmelze gehoben. Der Durchmesser des wachsenden Kristalls wird dabei automatisch oder manuell über die eingekoppelte HF-Leistung geregelt. Die Rotation von typischerweise 5-20 U/min begünstigt ein gleichmäßiges Wachstum des Kristalls.

## Patentansprüche

1. Tiegel zum Züchten von Einkristallen aus der Schmelze in im wesentlichen inerter Atmosphäre, dadurch gekennzeichnet, daß er aus gesintertem Rhenium besteht.

2. Tiegel nach Anspruch 1, dadurch gekennzeichnet, daß das gesinterte Rhenium eine Dichte von 88 - 95 % der theoretischen Dichte aufweist.

3. Tiegel nach Anspruch 1 oder 2, dadurch gekennzeichnet, daß er eine angeschweißte Halterung aus Rhenium aufweist.

4. Tiegel nach Anspruch 3, dadurch gekennzeichnet, daß die angeschweißte Halterung aus Rhenium-Draht besteht.

5. Verfahren zur Herstellung des Tiegels nach Anspruch 1 oder 2, dadurch gekennzeichnet, daß aus feinem Rhenium-Pulver durch isostatisches Kaltpressen mit einem Druck im Bereich von 300 - 700 MPa ein Tiegel-Preßling erzeugt und dieser bei 500 - 2800 °C im Vakuum gesintert wird.

6. Verfahren nach Anspruch 5, dadurch gekennzeichnet, daß Rhenium-Pulver mit einer Reinheit von mindestens 99,8 % eingesetzt wird.

7. Verfahren nach Anspruch 5 oder 6, dadurch gekennzeichnet, daß Rhenium-Pulver mit einer mittleren Korngröße von 1 - 20 Mikrometer eingesetzt wird.

8. Verfahren nach Anspruch 7, dadurch gekennzeichnet, daß Rhenium-Pulver mit einer mittleren Korngröße von 3 - 12 Mikrometer eingesetzt wird.

9. Verwendung des Tiegels nach einem der Ansprüche 1 bis 4 zum Züchten von Einkristallen aus hochschmelzenden Metalloxiden in im wesentlichen inerter Atmosphäre.

10. Verwendung nach Anspruch 9, dadurch gekennzeichnet, daß die hochschmelzenden Metalloxide Erdalkalimetalloxide oder -mischoxide sind.

11. Verwendung nach Anspruch 9, dadurch gekennzeichnet, daß die hochschmelzenden Metalloxide Seltenerdmetalloxide oder -mischoxide sind.

## Claims

1. Crucible for growing single crystals from the melt in a substantially inert atmosphere, characterized in that it consists of sintered rhenium.

2. Crucible according to Claim 1, characterized in that the sintered rhenium has a density of 88 - 95% of the theoretical density.

3. Crucible according to Claim 1 or 2, characterized in that it has a welded-on rhenium holder.

4. Crucible according to Claim 3, characterized in that the welded-on holder consists of rhenium wire.

5. Process for the production of the crucible according to Claim 1 or 2, characterized in that a crucible compact is produced from fine rhenium powder by isostatic cold pressing at a pressure in the range of 300 - 700 MPa and said compact is sintered at 500 - 2800°C in vacuo.

6. Process according to Claim 5, characterized in that rhenium powder having a purity of at least 99.8% is used.

7. Process according to Claim 5 or 6, characterized in that rhenium powder having a mean particle size of 1 - 20 micrometers is used.

8. Process according to Claim 7, characterized in that rhenium powder having a mean particle size of 3 - 12 micrometers is used.

9. Use of the crucible according to any of Claims 1 to 4 for growing single crystals of high-melting metal oxides in a substantially inert atmosphere.

10. Use according to Claim 9, characterized in that the high-melting metal oxides are alkaline earth metal oxides or alkaline earth metal mixed oxides.

11. Use according to Claim 9, characterized in that the high-melting metal oxides are rare earth metal oxides or rare earth metal mixed oxides.

## Revendications

1. Creuset pour produire des monocristaux à partir de la masse fondue dans une atmosphère sensiblement inerte, caractérisé en ce qu'il consiste en rhénium fritté.

2. Creuset selon la revendication 1, caractérisé en ce que le rhénium fritté présente une densité égale à 88-95 % de la densité théorique.

3. Creuset selon la revendication 1 ou 2, caractérisé en ce qu'il comporte une attache soudée en rhénium.

4. Creuset selon la revendication 3, caractérisé en ce que l'attache soudée consiste en fil de rhénium.

5. Procédé de fabrication du creuset selon la revendication 1 ou 2, caractérisé en ce qu'une ébauche de creuset est produite à partir d'une fine poudre de rhénium par compression isostatique à froid avec une pression située dans le domaine de 300 à 700 MPa et celle-ci est frittée à 500-2800°C sous vide.

6. Procédé selon la revendication 5, caractérisé en ce qu'une poudre de rhénium d'une pureté d'au moins 99,8 % est utilisée.

7. Procédé selon la revendication 5 ou 6, caractérisé en ce qu'une poudre de rhénium d'une granulométrie moyenne de 1-20 µm est utilisée.

8. Procédé selon la revendication 7, caractérisé en ce qu'une poudre de rhénium d'une granulométrie moyenne de 3-12 µm est utilisée.

9. Utilisation du creuset selon l'une des revendications 1 à 4 pour produire des monocristaux à partir d'oxydes métalliques à haut point de fusion dans une atmosphère sensiblement inerte.

10. Utilisation selon la revendication 9, caractérisée en ce que les oxydes métalliques à haut point de fusion sont des oxydes ou oxydes mixtes de métaux alcalino-terreux.

11. Utilisation selon la revendication 9, caractérisée en ce que les oxydes métalliques à haut point de fusion sont des oxydes ou oxydes mixtes de métaux des terres rares.
